Europäisches Patentamt

European Patent Office

Office européen des brevets

(11) Publication number: **0 169 060**
**B1**

# EUROPEAN PATENT SPECIFICATION

(45) Date of publication of patent specification: **31.08.88**

(21) Application number: **85305082.1**

(22) Date of filing: **17.07.85**

(51) Int. Cl.⁴: **H 01 B 1/22**

(54) **Solderable conductive compositions, their use as coatings on substrates, and compositions useful in forming them.**

(73) Proprietor: **ELECTRO MATERIALS CORP. OF AMERICA**
**605 Center Avenue**
**Mamaroneck New York 10543 (US)**

(72) Inventor: **St. John, Frank**
**1 Webster Place**
**Patterson New York (US)**
Inventor: **Shahbazi, Sanson**
**68 Highland Avenue**
**Yonkers New York 10705 (US)**

(74) Representative: **Angell, David Whilton**
**ROHM AND HAAS (UK) LTD. European Operations Patent Department Lennig House 2 Mason's Avenue**
**Croydon CR9 3NB (GB)**

(30) Priority: **18.07.84 US 631974**

(43) Date of publication of application:
**22.01.86 Bulletin 86/04**

(45) Publication of the grant of the patent:
**31.08.88 Bulletin 88/35**

(84) Designated Contracting States:
**AT BE CH DE FR GB IT LI LU NL SE**

(56) References cited:
**EP-A-0 140 585**
**EP-A-0 143 530**

**The file contains technical information submitted after the application was filed and not included in this specification**

Courier Press, Leamington Spa, England.

**Description**

This invention is concerned with conductive compositions that may be used in electronic applications such as electrical circuits on printed circuit boards, to methods useful in forming such conductive compositions, and to the coating of at least a portion of the surface of substrates with such conductive compositions. More particularly this invention is concerned with conductive compositions which are directly solderable and which can be bonded directly to substrates.

An electrically conductive composition applied to a supporting or base structure must be sufficiently conductive to carry electric current and must be firmly adhered or bonded to the support or base. Furthermore, it is desirable that the conductive composition be directly solderable.

U.S. Patent 3,030,237 discloses an improved coating material essentially comprised of organic resin carrier and a suitable metallic pigment. The invention of this U.S. Patent lies in the discovery that a coating having a metallic pigment component consisting of a mixture of ball and flake particles, having particular dimensions and used in certain proportions, in combination with an organic resin carrier, can exhibit good adhesion and electrical conductivity. Also disclosed is that conventional wire leads may be silver soldered to the cured coating using known silver soldering techniques.

U.S. Patent 2,959,498 discloses a method of forming conductive silver circuits by first applying, to a resinous dielectric surface, a layer of an incompletely cured thermosetting resin, then applying on said layer, in the outline of the desired conductive circuit, a layer of finely divided silver admixed with a thermoplastic resin containing a solvent for both of said resins, and then heating to cure both layers of applied resins. It is essential that the resinous dielectric surface is firstly coated with a thermosetting resin and that this resin is only partially cured before application of the conductive composition. The conductive circuit is applied over the undercoating of thermosetting resin, preferably by squeezing a silver paste in the desired electrical circuit pattern. The silver paste is composed of finely divided silver particles in a thermoplastic resin in a ratio of silver to resin of between 4:1 and 10:1. The resulting silver circuit pattern is firmly adhered to the resinous substrate and readily accepts solder.

U.S. Patent 4,371,459 discloses flexible screen-printable, conductor compositions comprising (a) a conductive phase containing silver and base metal powders dispersed in a solution of (b) a multipolymer prepared by copolymerization of vinyl acetate, vinyl chloride, and an ethylenically unsaturated dicarboxylic acid and a linear aromatic polyester resin dissolved in (c) volatile nonhydrocarbon solvent. These compositions are particularly useful for application to membrane touch switches.

EP—A1—0143530 discloses a solderable electrically conductive composition comprising metallic silver particles embedded in a matrix formed from acrylic, carboxylated vinyl and an epoxy. The composition is formed by dissolving acrylic powder and vinyl powder in respective solvents to form a first solution and a second solution. The solutions are then mixed with metallic silver particles and an epoxy to form an ink which is applied to a substrate to form a film thereon. The film is cured to evaporate the solvents and allow polymerization to occur thereby forming a solderable electrically conductive film.

Known conductive compositions developed for use in connection with supporting or base structures or other electrical equipment have generally been characterized by unacceptably high electrical resistivity or unacceptably low adhesion to the supporting or base material. Furthermore, many prior art compositions have the disadvantage that they are not directly solderable; that is, time consuming and expensive processes such as electroless plating are necessary in order to satisfactorily apply solder to the conductive composition. Compositions that are capable of being soldered are either not solderable by a variety of soldering techniques or do not accept the solder very well. Additionally, many of the prior art compositions cannot be bonded directly to the substrate onto which they are applied.

While some prior art compositions do avoid some of the above disadvantages, they have the disadvantage that complicated formulations employing additional compounds must be used and additional processing steps must be conducted. Furthermore, prior art compounds do not exhibit the characteristics of sufficient conductivity, and solderability, while at the same time being capable of direct bonding to substrates with outstanding adhesion resulting. Additionally, prior art compounds are generally cured at very high temperatures which places great energy demands on the process and adds to processing complications.

It has for a long time been desired to provide conductive compositions that have good conductivity, are directly solderable without having to resort to complicated procedures or formulations and which can be bonded directly to substrates with a high degree of adhesion resulting.

In our EP—A—0169059 there is claimed a flexible, directly solderable conductive composition comprising:—

(i) silver, substantially in the form of silver flake, the silver flake being particles in which the average distance across each particle is at least 5 times greater than the average thickness of the particle; and

(ii) resin system comprising:

(a) vinyl chloride/vinyl acetate copolymer having a number average molecular weight of from 14,000 to 35,000, having a weight ratio of vinyl chloride to vinyl acetate of from 80:20 to 90:10, and being free of carboxyl modification;

(b) non water-based epoxy resin that does not crosslink at room temperature; and

(c) epoxy hardener;

the weight ratio of silver to vinyl chloride/vinyl acetate copolymer plus epoxy resin plus epoxy hardener being from 88:12 to 95:5, and the epoxy resin/epoxy hardener being heat curable; with the proviso that the composition does not additionally comprise phenolic resin plus acrylic resin plus polyurethane resin such that the weight ratio of silver to vinyl chloride/vinyl acetate copolymer plus phenolic resin plus acrylic resin plus polyurethane resin plus epoxy resin plus epoxy hardener is from 75:25 to 90:10.

The present invention may enable the provision of conductive compositions that have good solder wetability, have excellent conductivity characteristics, can be bonded directly to substrates and/or are directly solderable, e.g. using a variety of techniques such as dip, reflow or wave soldering techniques. The compositions provided may have outstanding reflow solderability and high adhesion to a substrate onto which they may be applied.

The present invention may also enable the provision of compositions that can be cured at low temperatures.

According to one aspect of the present invention there is provided a directly solderable, conductive composition comprising:—

(i) Silver, substantially in the form of silver flake, the silver flake being particles in which the average diameter across each particle is at least 5 times greater than the average thickness of the particle; and

(ii) resin system comprising:—

(a) phenolic resin;

(b) acrylic resin;

(c) polyurethane resin;

(d) vinyl chloride/vinyl acetate copolymer having a number average molecular weight of from 14,000 to 35,000, having a weight ratio of vinyl chloride/vinyl acetate of from 80:20 to 90:10, and being free of carboxyl modification;

(e) non water-based epoxy resin that does not crosslink at room temperature; and

(f) epoxy hardener;

the weight ratio of silver to vinyl chloride/vinyl acetate copolymer plus phenolic resin plus acrylic resin plus polyurethane resin plus epoxy resin plus epoxy hardener being from 75:25 to 90:10, and the epoxy resin/epoxy hardener being heat curable.

According to a further aspect of the present invention there is provided a method of preparing a composition useful in forming a directly solderable, conductive composition of the invention, the method comprising mixing together:—

(a) a first solution comprising the phenolic resin, acrylic resin, polyurethane resin, non water-based epoxy resin and epoxy hardener substantially dissolved in ester solvent;

(b) a second solution comprising the vinyl chloride/vinyl acetate copolymer dissolved in ketone solvent, and

(c) the silver;

the weight ratio of silver to phenolic resin plus acrylic resin plus polyurethane resin plus vinyl chloride/vinyl acetate copolymer plus epoxy resin plus epoxy hardener being from 75:25 to 90:10, such that the silver is substantially dispersed and substantially wetted.

The silver, which is preferably exclusively in the form of silver flake, is conveniently distributed throughout the resin system.

The resin system may not only hold the silver in suspension, but may also provide adhesion of the silver to a substrate, hold the silver together such that a conductive path is formed, and provide flexibility. Furthermore, after curing, on a substrate, a coating of a composition comprising the silver and resin system, the region of the coating adjacent to the substrate may be found to have a higher concentration of the resin than the region of the coating adjacent the coating surface, thus leaving a highly enriched silver layer in the region of the surface of the coating.

The compositions of the present invention are conveniently applied in the liquid state to substrates, that is, the compositions are conveniently mixed with solvent which acts as a vehicle. Once applied to the substrate the compositions can be cured and the solvent evaporated leaving dried, cured compositions that contain only traces, if any, of solvent. In the following discussion, ratios of certain components employed are disclosed and it is to be noted that, unless otherwise indicated, these ratios relate to the composition in its dried and cured state, not to the compositions in their liquid state during the process of manufacture, that is, not to the compositions containing solvent.

It is important to note that, for the purpose of the present invention, the silver employed is substantially in the form of silver flake and is preferably 100% silver flake. Silver in other forms, for example, ball or mixtures of ball and flake, which are not substantially in the form of silver flake, will not lead to the production of compositions demonstrating the advantages of the compositions according to the present invention. For the purposes of the present invention a particle is considered to be in flake form when the distance across (i.e. the average distance across) the particle is at least five times greater than the thickness (i.e. the average thickness) of the particle. Preferably, the distance across the particle is at least ten times greater than the thickness of the particle. The presence of only silver substantially in the form of silver flake has a further advantage in that it (i.e. the silver flake) appears to contribute to reducing or eliminating silver migration problems seen in prior art compositions. The average particle size of the silver flake (i.e. the overall average of the distance across the silver flakes) may be from about 0.5 micrometres to 50 micrometres, preferably from about 2 micrometres to about 4 micrometres. It is, however to be understood that, when the average particle size of the silver flake is from 0.5 to 50 micrometres, silver flake particles may be present having a particle size of less than 0.5 micrometres or more than 50 micrometres. If the average particle size of the silver flake is less than 0.5 micrometres, there will be difficulty in getting the compositions to load the silver. If the silver is too fine, the consistency of the composition will be too clay-like. If the average particle size of the silver flake is above about 50 micrometres, then the composition will be difficult to apply. For example, the composition will tend to clog up during processes such as screening. The cured compositions of the invention may, for example, contain from about 88% to 93%, by weight, silver flake.

The vinyl chloride/vinyl acetate copolymers used have a number average molecular weight range of from 14,000 to 35,000, preferably about 20,000. Vinyl chloride/vinyl acetate copolymers having a molecular weight at the higher end of this molecular weight range have better durability and toughness characteristics than vinyl chloride/vinyl acetate copolymers having molecular weights at the lower end of the molecular weight range. We have found that types of vinyl acetate/vinyl chloride copolymer other than the vinyl chloride/vinyl acetate copolymers used in the present invention, are unsatisfactory. We tested a carboxyl modified vinyl chloride/vinyl acetate copolymer having a weight ratio of vinyl chloride to vinyl acetate to maleic acid of 83:16:1. Compositions made with this product were found to deteriorate when solder is applied thereto. Apparently, the presence of the dicarboxylic acid is detrimental to the solderability of the conductive compositions when used in screen printing applications for electronic circuit boards. We have also investigated the use of a polyvinyl buterol, which is a modified polyvinyl alcohol. However, the composition made with this resin was also found to disintegrate when solder was applied to it. The compositions of the present invention require a high performance vinyl chloride/vinyl acetate copolymer; vinyl chloride/vinyl acetate copolymers having a number average molecular weight of less than 14,000 or carboxyl modified vinyl chloride/vinyl acetate copolymers are unsuitable.

The weight ratio of vinyl chloride to vinyl acetate in the vinyl chloride/vinyl acetate copolymers used in the present invention is from about 80:20 to about 90:10, preferably from about 86:16 to about 88:12. A vinyl chloride/vinyl acetate copolymer having a number average molecular weight of 35,000 may have a weight ratio of vinyl chloride to vinyl acetate of about 90:10; and a vinyl chloride/vinyl acetate copolymer having a number average molecular weight of 14,000 may have a weight ratio of vinyl chloride to vinyl acetate of about 86.14.

The epoxy resin employed as part of the resin system can be any type of epoxy resin, e.g. a commercially available epoxy resin, that is non water-based and does not crosslink at room temperature. A suitable epoxy resin is that designated Araldite 6010, sold by Ciba Geigy, this resin being an unmodified liquid epoxy resin of medium viscosity which is based on bisphenol A and epichlorohydrin. The epoxy hardener employed as part of the resin system may, for example, be the material designated HY940 which is a moderately high viscosity dispersion of a solid polyamide in a liquid epichlorohydrin-bisphenol epoxy resin and is supplied by Ciba Geigy. The purpose of the epoxy hardener is to crosslink, under curing conditions, with the epoxy resin to form a solid; the epoxy resin and epoxy hardener employed must not crosslink at room temperature. The epoxy resin/epoxy hardener is conveniently a one step heat-curable system, and should be compatible with the other ingredients such as the solvent. Additionally, the epoxy resin is not a water-based epoxy resin i.e. is organic solvent-based.

The phenolic resin used should be heat-curable and may, for example, be a one step, heat-curing, long chain, solid phenolic resin sold by Reichhold Chemical Company under the trade name Varcum 29-112. However, other similar types of phenolic resin, which do not crosslink at room temperature, may, for example, be used. The number average molecular weight of the phenolic resin should preferably be greater than 400 and less than 1000. Also, the phenolic resin should be soluble in ester solvent.

The acrylic resin used may, for example, be a solid acrylic resin sold by Rohm and Haas Company under the trade designation Acryloid B-66. However, other acrylic resins, which are soluble in ester solvent, may, for example, be used.

The polyurethane resin used may, for example, be the polyurethane resin sold by the B. F. Goodrich Company under the trade designation Estane 5702, and having a glass transition temperature of from −10°C to −50°C. Other polyurethane resins having a glass transition temperature within this range may be used.

The ratio of silver to phenolic resin plus acrylic resin plus polyurethane resin plus vinyl chloride/vinyl acetate copolymer plus epoxy resin plus epoxy hardener is important. If these components are not used within the ranges of ratios specified, the compositions produced will not possess all of the characteristics hereinbefore described. In the broadest sense, the weight ratio of silver to phenolic resin plus acrylic resin plus polyurethane resin plus vinyl chloride/vinyl acetate copolymer plus epoxy resin plus epoxy hardener should be from about 75:25 to about 90:10; preferably from about 80:20 to about 85:15.

In the resin system, the ratio of epoxy resin to epoxy hardener may, for example, be from about 45:55 to about 30:70.

The composition of this invention may, for example, have silver flake present in an amount of from about 80% to about 85% by weight, the phenolic resin present in an amount of from about 0.6% to about 1.6% by weight, the polyurethane resin present in an amount of from about 0.4% to about 0.8% by weight, the acrylic resin present in an amount of from about 0.8% to about 1.6% by weight, the vinyl chloride/vinyl acetate copolymer present in an amount of from about 1.2% to about 3.5% by weight, the epoxy resin present in an amount of from about 1.0% to about 3.0% by weight, and the epoxy hardener present in an amount of about 2.5% to about 4.0% by weight, all percentages being based on the total weight of the silver, phenolic resin, acrylic resin, polyurethane resin, vinyl chloride/vinyl acetate copolymer, epoxy resin and epoxy hardener.

An advantage of the conductive compositions of the present invention is that they are directly solderable. This means that they accept solder directly without the need to resort to use time consuming and expensive procedures such as electroless plating. The conductive compositions can be soldered by any of a number of methods, for example, by dip or reflow soldering techniques, provided the solder temperature does not exceed 205°C. Of course, the need to use a solder flux is not obviated by the conductive compositions of the present invention. Solder flux is a resin based material that aids the wettability of materials to be soldered (e.g. the conductive compositions of the invention is non-conductive, is widely used and is generally a liquid. In the present invention, the flux can be applied in a variety of ways. For example, pre-fluxing can be employed wherein the conductive composition to be soldered is first dipped into liquid flux and then the solder is applied while the composition is still wet with flux. Alternatively, the flux can be a component of a solder-alloy mixture, in which the vehicle is the flux and pre-fluxing is not required. Additionally, the flux may also be activated or not activated. Activated flux cleans the surface to be soldered.

As previously indicated the compositions of the invention are conveniently applied in liquid form to substrates and the compositions are then cured. The compositions of the invention can be applied to a variety of substrates that may be made from a variety of materials. The substrate may be flexible or rigid and may, for example, be of a variety of types such as resinous or ceramic. Examples of suitable substrates include printed circuit boards. The only limitation on the substrate is that it should be able to withstand the soldering conditions without being deformed or destroyed.

Compositions useful in forming the conductive compositions of this invention may be made by substantially dissolving phenolic resin, acrylic resin, polyurethane resin, epoxy resin, epoxy hardener in ester solvent to form a first solution, dissolving vinyl chloride/vinyl acetate copolymer in ketone solvent to form a second solution and mixing the first and second solutions with silver, substantially in the form of flake, to form a mixture such that the silver is substantially wetted and substantially dispersed. The weight ratio of the silver to the first solution to the second solution may, for example, be from about 65:20:15 to about 80:10:10. The weight ratio of phenolic resin plus acrylic resin plus polyurethane resin plus epoxy resin plus epoxy hardener to solvent in the first solution may, for example, be from about 1:1 to about 1:2 and the weight ratio of phenolic resin plus acrylic resin plus polyurethane resin plus epoxy resin plus epoxy hardener to solvent in the second solution may, for example, be from about 3:1 to about 9:1.

With respect to the total mixture the silver may, for example, be present in an amount of from about 65% to about 80% by weight, the first solution may, for example, be present in an amount of from about 10% to about 20% by weight, and the second solution may, for example, be present in an amount of from about 10% to about 15% by weight, all percentages being based on the total weight of the silver, phenolic resin, acrylic resin, polyurethane resin, vinyl chloride/vinyl acetate copolymer, epoxy resin and epoxy hardener.

No special techniques are required in carrying out the method of this invention other than that the phenolic resin, acrylic resin, polyurethane resin and epoxy hardeners must be substantially dissolved in an ester solvent and the vinyl chloride/vinyl acetate copolymer must be dissolved in a ketone solvent. The silver may, for example be added by any conventional technique. The ketone solvent may be any ketone solvent, for example, gamma butyrolactone, acetone or cyclohexanone. The ester solvent can be any ester solvent, for example, butyl Carbitol acetate; butyl Carbitol acetate is diethylene-glycol monobutyl ether acetate and is an ester solvent supplied by Union Carbide.

Prior to the application of the composition to a substrate the fineness of grind is conveniently checked to determine if it is 25 micrometres or less. Fineness of grind may, for example be checked using any standard technique employing a fineness of grind gauge. If the fineness of the grind is not 25 micrometres or less, then the composition should preferably be passed through a 3 roll mill until fineness of grind of 25 micrometres or less is obtained. Using feeler gauges, the roll gaps should be set as follows: 0.051 mm (0.002") gap between the apron roll and middle roll and 0.38 mm (0.015") gap between the middle roll and back roll. The composition should preferably not be passed through the 3 roll mill more than three times. Additionally, the viscosity of the composition should preferably range from about 30 to about 100 Pa·s (30,000 c.p.s. to 100,000 c.p.s.) at 25°C when measured using a standard Brookfield viscometer. Preferably, the viscosity is from 30 to 70 Pa·s (30,000 c.p.s. to 70,000 c.p.s.).

The mixture so formed can be applied to a substrate by any of a number of techniques, for example by silk screening, spraying or brushing. The mixture can be applied at a thickness of 0.025 mm (1 mil) or more. Once applied to the substrate, the mixture is dried and cured, for example, at a temperature of from about 100°C to about 170°C for about 15 to about 60 minutes. The drying and curing, may, for example, be carried out by any of a number of techniques such as baking in an oven.

The compositions of this invention may be bonded directly to substrates. A method of applying a conductive composition onto a substrate comprises bonding the conductive composition directly to the substrate, the conductive composition comprising silver, substantially in the form of flake, and resin system comprising phenolic resin, acrylic resin, polyurethane resin, vinyl chloride/vinyl acetate copolymer, epoxy resin, and epoxy hardener. The substrate does not need to have been precoated or pretreated with any composition or by any process. The compositions according to the invention, after drying and curing, demonstrate excellent adhesion to the substrate. Typically, the average force required to remove the composition from a rigid substrate is greater than 6.895 MPa gauge (1000 p.s.i.g.).

A method for measuring the force required to remove (or destroy) the conductive composition according to the present invention from a rigid substrate, involves coating a pad of the conductive composition onto the substrate, the pad being 2.54 mm (one tenth of an inch) square. A 22 gauge tin coated copper wire is then soldered onto the pad perpendicular to the substrate. The force required to tear the pad off the substrate is then measured by conventional means. Any failure is in the ability of the pad to adhere to the substrate, not in the wire adhering to the pad. Any removal of the conductive composition or deterioration of the composition is considered a failure.

The present invention will now be further illustrated by way of the following example which is for illustrative purposes only and is not to be construed as imposing any limitations on the scope of the invention.

Although the following Example utilizes a vinyl chloride/vinyl acetate copolymer designed VYHH supplied by Union Carbide, other types of vinyl chloride/vinyl acetate copolymer may be employed as long as the copolymer conforms to the specifications hereinbefore described.

Example
Method of making a composition according to the invention and use thereof as a coating

The following ingredients were mixed together and dissolved in 83.3 grams butyl Carbitol acetate to make a first solution:

16.6 grams varcum 29-112
14.3 grams Acryloid B-66
9.0 grams Estane 5702
47.5 grams Araldite 6010
29.4 grams epoxy hardener—HY940
20 grams of vinyl chloride/vinyl acetate copolymer,

having a number average molecular weight of 20,000, was dissolved in 80 grams of gamma butyrolactone to form a second solution.

The two solutions and 700 grams of silver flakes having an average particle size of 23 micrometres. The silver flakes were blended into the solution so that the flakes were wetted and dispersed.

The fineness of grind of this mixture was checked and found to be 23 micrometres.

The resultant mixture was applied to a printed circuit board by silk screening and then cured for 30 minutes at 165°C.

"Araldite", "Acryloid", "Estane" and "Carbitol" are trade marks which may be registered in some or all of the designated states.

**Claims**

1. A directly solderable, conductive composition comprising:—
   (i) Silver, substantially in the form of silver flake, the silver flake being particles in which the average diameter across each particle is at least 5 times greater than the average thickness of the particle; and
   (ii) resin system comprising:—
   (a) phenolic resin;
   (b) acrylic resin;
   (c) polyurethane resin;
   (d) vinyl chloride/vinyl acetate copolymer having a number average molecular weight of from 14,000 to 35,000, having a weight ratio of vinyl chloride/vinyl acetate of from 80:20 to 90:10, and being free of carboxyl modification;
   (e) non water-based epoxy resin that does not crosslink at room temperature; and
   (f) epoxy hardener;
   the weight of silver to vinyl chloride/vinyl acetate copolymer plus phenolic resin plus acrylic resin plus polyurethane resin plus epoxy resin plus epoxy hardener being from 75:25 to 90:10, and the epoxy resin/epoxy hardner being heat curable.

2. A composition as claimed in claim 1, wherein the weight ratio of epoxy resin to epoxy hardener is from 45:55 to 30:70.

3. A composition as claimed in claim 1, wherein the silver is present in an amount of from 80% to 85% by weight, the phenolic resin is present in an amount of from 0.6% to 1.6% by weight, the acrylic resin is present in an amount of from 0.8% to 1.6% by weight, the polyurethane resin is present in an amount of from 0.4% to 0.8% by weight, the vinyl chloride/vinyl acetate copolymer is present in an amount of from 1.2%, to 3.5% by weight, the epoxy resin is present in an amount of from 1.0% to 3.0% by weight, and the epoxy hardener is present in an amount of from 2.5% to 4.0% by weight, the percentages being based on the total weight of the silver, phenolic resin, acrylic resin, polyurethane resin, vinyl chloride/vinyl acetate copolymer, epoxy resin and epoxy hardener.

4. A composition as claimed in any of claims 1 to 3, wherein the overall average of the distance across the silver flakes is from 0.5 micrometres to 50 micrometres.

5. A composition as claimed in any of claims 1 to 4, wherein the silver is exclusively in the form of silver flake.

6. An article, which comprises a substrate, at least a portion of the surface of which is coated with a composition as claimed in any of claims 1 to 5.

7. A method of soldering a conductive composition as claimed in any of claims 1 to 5, which comprises applying solder, at a temperature of up to 205°C, directly to the conductive composition.

8. A method as claimed in claim 7, wherein the solder is applied by a dip or reflow soldering technique.

9. A method of preparing a composition useful in forming a directly solderable, conductive composition as claimed in any of claims 1 to 5, the method comprising mixing together:—

(a) a first solution comprising said phenolic resin, acrylic resin, polyurethane resin, non water-based epoxy resin and epoxy hardener substantially dissolved in ester solvent;

(b) a second solution comprising said vinyl chloride/vinyl acetate copolymer dissolved in ketone solvent; and

(c) said silver; the weight ratio of silver to phenolic resin plus acrylic resin plus polyurethane resin plus vinyl chloride/vinyl acetate copolymer plus epoxy resin plus epoxy hardener being from 75:25 to 90:10.

10. A method as claimed in claim 9, wherein:

(i) the weight ratio of silver to the first solution to the second solution is from 65:20:15 to 80:10:10, and/or

(ii) the weight ratio of total phenolic resin plus acrylic resin plus polyurethane resin plus epoxy resin plus epoxy hardener to solvent in the first solution is from 1:1 to 1:2 and the weight ratio of total vinyl chloride/vinyl acetate copolymer to solvent in the second solution is from 3:1 to 9:1.

11. A method as claimed in claim 9, wherein the silver is present in an amount of from 65% to 80% by weight, the first solution is present in an amount of from 10% to 20% by weight, and the second solution is present in an amount of from 10% to 15% by weight, the percentages being based on the total weight of the silver, phenolic resin, acrylic resin, polyurethane resin, vinyl chloride/vinyl acetate copolymer, epoxy resin, epoxy hardener, ketone solvent and ester solvent.

12. A method as claimed in any of claims 9 to 11, wherein the silver is exclusively in the form of silver flake.

13. A method, which comprises applying to a substrate a composition prepared by a method as claimed in any of claims 9 to 12, and then drying and curing the composition.

14. A method as claimed in claim 13, wherein the composition is dried and cured at a temperature of from 125°C to 180°C for 15 minutes to 120 minutes.

**Patentansprüche**

1. Direkt lötbare leitende Masse aus

(i) Silber, im wesentlichen in Form von Silberflocken, wobei die Silberflocken Teilchen sind, in denen der durchschnittliche Durchmesser quer zu jedem Teilchen wenigstens 5 mal größer ist als die durchschnittliche Dicke des Teilchens, und

(ii) einem Harzsystem aus

(a) einem Phenolharz,

(b) einem Acrylharz,

(c) einem Polyurethanharz,

(d) einem Vinylchlorid/Vinylacetat-Copolymeren mit einem Zahlenmittel des Molekulargewichts von 14000 bis 35000 und einem Gewichtsverhältnis Vinylchlorid/Vinylacetat von 80:20 bis 90:10, das frei von Carboxylmodifikation ist,

(e) einem Epoxyharz auf Nichtwasser-Basis, das bei Zimmertemperatur vernetzt und

(f) einem Epoxyhärter,

wobei das Gewichtsverhältnis von Silber zu Vinylchlorid/Vinylacetat-Copolymerem plus Phenylharz plus Acrylharz plus Polyurethanharz plus Epoxyharz plus Epoxyhärter 75:25 bis 90:10 beträgt und die Mischung Epoxyharz/Epoxyhärter durch Wärme härtbar ist.

2. Masse nach Anspruch 1, wobei das Gewichtsverhältnis von Epoxyharz zu Epoxyhärter 45:55 bis 30:70 beträgt.

3. Masse nach Anspruch 1, wobei das Silber in einer Menge von 80 bis 85 Gew.-%, das Phenolharz in einer Menge von 0,6 bis 1,6 Gew.-%, das Acrylharz in einer Menge von 0.8 bis 1,6 Gew.-%, das Polyurethanharz in einer Menge von 0,4 bis 0,8 Gew.-%, das Vinylchlorid/Vinylacetat-Copolymere in einer Menge von 1,2 bis 3,5 Gew.-%, das Epoxyharz in einer Menge von 1,0 bis 3,0 Gew.-% und der Epoxyhärter in einer Menge von 2,5 bis 4,0 Gew.-% vorliegt, wobei sich die Prozentsätze auf das Gesamtgewicht an Silber, Phenolharz, Acrylharz, Polyurethanharz, Vinylchlorid/Vinylacetat-Copolymeren, Epoxyharz und Epoxyhärter beziehen.

4. Masse nach einem der Ansprüche 1 bis 3, wobei der Gesamtdurchschnitt des Abstandes quer zu Silberflocken 0,5 μm bis 50 μm beträgt.

5. Masse nach einem der Ansprüche 1 bis 4, wobei das Silber ausschließlich in Form von Silberflocken vorliegt.

6. Gegenstand aus einem Substrat, wobei wenigstens ein Teil der Oberfläche mit einer Masse gemäß einem der Ansprüche 1 bis 5 beschichtet ist.

7. Verfahren zum Löten einer leitenden Masse gemäß einem der Ansprüche 1 bis 5, wobei ein Lötmittel bei einer Temperatur von bis zu 205°C direkt auf die leitende Masse aufgebracht wird.

8. Verfahren nach Anspruch 7, wobei das Lötmittel durch Eintauchen oder durch Aufschmelzen aufgebracht wird.

9. Verfahren zur Herstellung einer Masse, die zur Herstellung einer direkt lötbaren leitenden Masse gemäß einem der Ansprüche 1 bis 5 geeignet ist, wobei das Verfahren darin besteht, folgende Bestandteile miteinander zu vermischen:

(a) eine erste Lösung aus dem Phenolharz, Acrylharz, Polyurethanharz, Epoxyharz auf Nichtwasserbasis und Epoxyhärter, im wesentlichen aufgelöst in einem Etherlösungsmittel,

(b) eine zweite Lösung aus Vinylchlorid/Vinylacetat-Copolymerem, gelöst in einem Ketonlösungsmittel und

(c) Silber, wobei das Gewichtsverhältnis von Silber zu Phenolharz plus Acrylharz plus Polyurethanharz plus Vinylchlorid/Vinylacetat-Copolymerm plus Epoxyharz plus Epoxyhärter 75:25 bis 90:10 beträgt.

10. Verfahren nach Anspruch 9, wobei

(i) das Gewichtsverhältnis Silber/erste Lösung/zweite Lösung 65:20:15 bis 80:10:10 beträgt und/oder

(ii) das Gewichtsverhältnis von gesamtem Phenolharz plus Acrylharz plus Polyurethanharz plus Epoxyharz plus Epoxyhärter zu dem Lösungsmittel in der ersten Lösung 1:1 bis 1:2 beträgt und das Gewichtsverhältnis des gesamten Vinylchlorid/Vinylacetat-Copolymeren in dem Lösungsmittel in zweiten Lösung 3:1 bis 9:1 beträgt.

11. Verfahren nach Anspruch 9, wobei das Silber in einer Menge von 65 bis 80 Gew.-%, die erste Lösung in einer Menge von 10 bis 20 Gew.-% und die zweite Lösung in in einer Menge von 10 bis 15 Gew.-% vorliegt, wobei sich die Prozentsätze auf das Gesamtgewicht aus Silber, Phenolharz, Acrylharz, Polyurethanharz, Vinylchlorid/Vinylacetat-Copolymerem, Epoxyharz, Epoxyhärter, Ketonlösungsmittel und Esterlösungsmittel beziehen.

12. Verfahren nach einem der Ansprüche 9 bis 11, wobei das Silber ausschließlich in Form von Silberflocken verwendet wird.

13. Verfahren, welches darin besteht, auf ein Substrat eine Masse aufzubringen, die nach einem Verfahren gemäß einem der Ansprüche 9 bis 12 hergestellt worden ist, worauf die Masse getrocknet und gehärtet wird.

14. Verfahren nach Anspruch 13, wobei die Masse getrocknet und bei einer Temperatur von 125 bis 180°C während 15 bis 120 Minuten gehärtet wird.

**Revendications**

1. Une composition conductrice directement soudable comprenant:

(i) de l'argent essentiellement sous forme de paillettes d'argent, les paillettes d'argent étant des particules ayant un diamètre moyen transversalement à chaque particule au moins cinq fois supérieur à l'épaisseur moyenne de la particule; et

(ii) un système de résines comprenant:
(a) une résine phénolique;
(b) une résine acrylique;
(c) une résine de polyuréthane;
(d) un copolymère de chlorure de vinyle/acétate de vinyle ayant une moyenne numérique du poids moléculaire de 14 000 à 35 000, ayant un rapport pondéral chlorure de vinyle/acétate de vinyle de 80/20 à 90/10 et étant dépourvu de modification carboxylique;
(e) une résine époxyde qui n'est pas à base d'eau et qui ne se réticule pas à la température ambiante; et
(f) un durcisseur époxyde;
le rapport pondéral de l'argent à la somme du copolymère de chlorure de vinyle/acétate de vinyle, de la résine phénolique, de la résine acrylique, de la résine de polyuréthane, de la résine époxyde et du durcisseur époxyde étant de 75/25 à 90/10, et la résine époxyde/durcisseur époxyde étant thermodurcissable.

2. Une composition comme revendiqué dans la revendication 1 où le rapport pondéral de la résine époxyde au durcisseur époxyde est de 45/55 à 30/70.

3. Une composition comme revendiqué dans la revendication 1 où l'argent est présent en une quantité de 80% à 85% en poids, la résine phénolique est présente en une quantité de 0,6% à 1,6% en poids, la résine acrylique est présente en une quantité de 0,8% à 1,6% en poids, là résine de polyuréthane est présente en une quantité de 0,4% à 0,8% en poids, le copolymère de chlorure de vinyle/acétate de vinyle est présent en une quantité de 1,2% à 3,5% en poids, la résine époxyde est présente en une quantité de 1,0% à 3,0% en poids et le durcisseur époxyde est présent en une quantité de 2,5% à 4,0% en poids, les pourcentages étant exprimés relativement au poids total de l'argent, la résine phénolique, la résine acrylique, la résine de polyuréthane, le copolymère de chlorure de vinyle/acétate de vinyle, la résine époxyde et le durcisseur époxyde.

4. Une composition comme revendiqué dans l'une quelconque des revendications 1 à 3, où la moyenne globale de la distance transversale des paillettes d'argent est de 0,5 micromètre à 50 micromètres.

5. Une composition comme revendiqué dans l'une quelconque des revendications 1 à 4, dans laquelle l'argent est exclusivement sous forme de paillettes d'argent.

6. Un article qui comprend un substrat dont au moins une portion de la surface est revêtue d'une composition comme revendiqué dans l'une quelconque des revendications 1 à 5.

7. Un procédé de soudage d'une composition conductrice comme revendiqué dans l'une quelconque des revendications 1 à 5, qui comprend l'application de soudure, à une température allant jusqu'à 205°C, directement à la composition conductrice.

8. Un procédé comme revendiqué dans la revendication 7, dans lequel la soudure est appliquée selon une technique de soudage au trempé ou par fusion et resolidification.

9. Un procédé de préparation d'une composition utile pour former une composition conductrice directement soudable comme revendiqué dans l'une quelconque des revendications 1 à 5, lequel procédé comprend le mélange mutuel de:

(a) une première solution comprenant lesdites résine phénolique, résine acrylique, résine de polyuréthane, résine époxyde qui n'est pas à base d'eau, et durcisseur époxyde, essentiellement dissous dans un solvant de type ester;

(b) une seconde solution comprenant ledit copolymère de chlorure de vinyle/acétate de vinyle dissous dans un solvant de type cétone; et

(c) ledit argent;

le rapport pondéral de l'argent à la somme de la résine phénolique, de la résine acrylique, de la résine de polyuréthane, du copolymère de chlorure de vinyle/acétate de vinyle, de la résine époxyde et du durcisseur époxyde étant de 75/25 à 90/10.

10. Un procédé comme revendiqué dans la revendication 9, où:

(i) le rapport pondéral de l'argent à la première solution et à la seconde solution est de 65/20/15 à 80/10/10 et/ou

(ii) le rapport pondéral de la somme de la résine phénolique, la résine acrylique, la résine de polyuréthane, la résine époxyde et le durcisseur époxyde au solvant dans la première solution est de 1/1 à 1/2 et le rapport pondéral de la totalité du copolymère de chlorure de vinyle/acétate de vinyle au solvant dans la seconde solution est de 3/1 à 9/1.

11. Un procédé comme revendiqué dans la revendication 9, où l'argent est présent en une quantité de 65% à 80% en poids, la première solution est présente en une quantité de 10% à 20% en poids et la seconde solution est présente en une quantité de 10% à 15% en poids, les pourcentages étant exprimés relativement au poids total de l'argent, la résine phénolique, la résine acrylique, la résine de polyuréthane, le copolymère de chlorure de vinyle/acétate de vinyle, la résine époxyde, le durcisseur époxyde, le solvant de type cétone et le solvant de type ester.

12. Un procédé comme revendiqué dans l'une quelconque des revendications 9 à 11, où l'argent est exclusivement sous forme de paillettes d'argent.

13. Un procédé qui comprend l'application à un substrat d'une composition préparée selon un procédé comme revendiqué dans l'une quelconque des revendications 9 à 12, puis le séchage et le durcissement de la composition.

14. Un procédé comme revendiqué dans la revendication 13 où la composition est séchée et durcie à une température de 125°C à 180°C pendant 15 minutes à 120 minutes.